(19) Europäisches Patentamt
European Patent Office
Office européen des brevets

(11) Publication number: 0 490 883 A1

# (12) EUROPEAN PATENT APPLICATION

(21) Application number: **92104124.0**

(22) Date of filing: **07.09.87**

(51) Int. Cl.$^5$: **C23C 16/48**

This application was filed on 11 - 03 - 1992 as a divisional application to the application mentioned under INID code 60.

(30) Priority: **09.09.86 JP 213323/86**
**09.09.86 JP 213324/86**
**09.09.86 JP 213325/86**
**05.06.87 JP 141050/87**

(43) Date of publication of application:
**17.06.92 Bulletin 92/25**

(60) Publication number of the earlier application in accordance with Art.76 EPC: **0 260 097**

(84) Designated Contracting States:
**DE FR GB**

(71) Applicant: **SEMICONDUCTOR ENERGY LABORATORY CO., LTD.**
**398 Hase**
**Atsugi-shi Kanagawa-ken, 243(JP)**

(72) Inventor: **Takayama, Touru**
**Flat Atsugi 305, 931-1, Hase**
**Atsugi-Shi, Kanagawa-Ken 243(JP)**
Inventor: **Inujima, Takashi**
**1-29-2-204 Morinosato**
**Atsugi-Shi, Kanagawa-Ken 243-01(JP)**
Inventor: **Odakaa, Seiichi**
**TDK Matsukazeryo A401, 58 Kanmuriishishita**
**Kisakata-Machi, Akita-Ken 018-01(JP)**
Inventor: **Hirose, Naoki**
**Flat Atsugi 205, 931-1, Hase**
**Atsugi-Shi, Kanagawa-Ken 243(JP)**
Inventor: **Hayashi, Shigenori**
**Flat Atsugi 201, 931-1, Hase**
**Atsugi-Shi, Kanagawa-Ken 243(JP)**

(74) Representative: **Milhench, Howard Leslie et al**
**R.G.C. Jenkins & Co. 26 Caxton Street**
**London SW1H 0RJ(GB)**

## (54) CVD apparatus.

(57) An improved CVD (chemical vapour deposition) apparatus (1) for depositing a uniform film comprises a reaction chamber (3), a substrate holder (7) and a plurality of light sources (5) for photo CVD and a pair of electrodes (49) for plasma CVD, the light sources (5) comprising UV discharge lamps (19) housed within quartz tubes (17) which are hermetically sealed from the reaction chamber. The substrate holder (7) is a cylindrical multifaceted prism which is encircled by the light sources (5) and electrodes (49), and which is arranged to be rotated about its axis during the CVD process by a driving device (9). The apparatus (1) enables substrates mounted on the substrate holder to be uniformly exposed to the CVD enhancement effects of light and plasma so that even CVD layers are obtained throughout the surfaces to be coated.

EP 0 490 883 A1

FIG.2

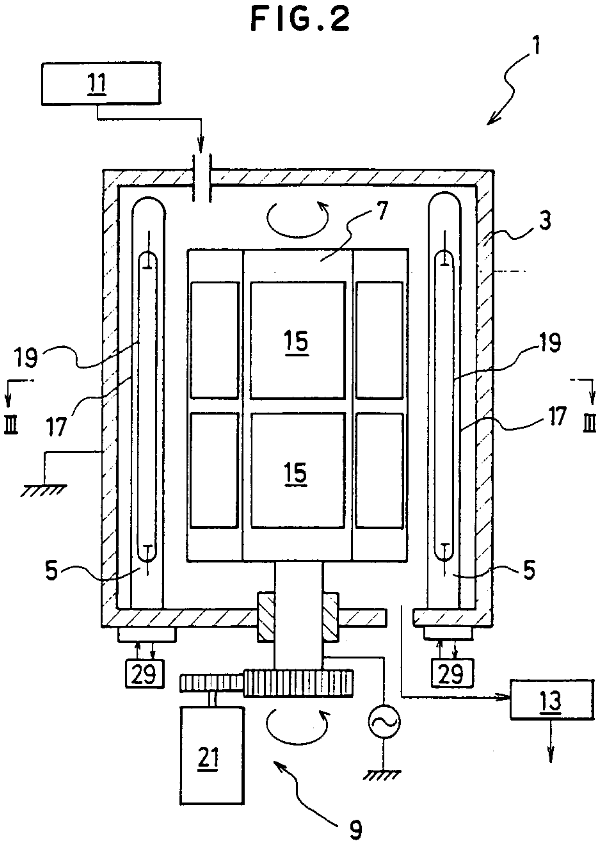

## BACKGROUND OF THE INVENTION

This invention relates generally to CVD apparatuses and more particularly concerns photo enhanced CVD apparatuses.

There are many chemical vapor deposition (CVD) processes such as AP (Atmospheric pressure) CVD, LP (Low Pressure) CVD, plasma CVD, thermal CVD and so forth that are used for depositing a film on a substrate. While these processes each have their own peculiar characteristics, generally speaking the temperature at which each process is carried out is rather high. Such a high temperature process is not suitable for the formation of a passivation film on an aluminium electrode arrangement, for example.

Photo enhanced CVD processes have attracted the interest of artisans because they can be carried out at comparatively low temperatures. The photo enhanced CVD process is based on the energy of light, namely an optical reaction is carried out. For example, in the case of a photo CVD process using silane and ammonia, mercury atoms are excited by irradiation of ultraviolet light of 2,537Å ($1Å = 10^{-10}m$) wavelength. The process is carried out to deposit a silicon nitride film on a substrate in accordance with the following equation:

Hg + hv ---> Hg* ("*" is a symbol for excitation)
$Hg^* + SiH_4$ ---> $SiH_3$ + H- + Hg ("-" is a symbol for a radical)
$Hg^* + NH_3$ ---> $NH_2$- + H- + Hg
$yNH_2$- + $xSiH_3$ ---> $Si_xN_y$ $zH_2$

In the above equations, x, y and z are chosen appropriately.

Fig. 1 of the accompanying drawings is a cross sectional view showing an exemplary photo CVD apparatus which has previously been devised by the inventors of the present invention. To facilitate an understanding of the background of the present invention, this apparatus will now be briefly explained. As shown in Fig. 1, the apparatus comprises a reaction chamber 31, light source chambers 39 and ultraviolet light sources 41 within the chambers 39. Between the light source chambers 39, a carrier 35 is mounted so as to be capable of moving in the direction perpendicular to the drawing sheet. The carrier is provided with heaters 37 to heat substrates 33 mounted as shown on the external surfaces of the carrier 35 facing the light source chambers 39. The temperature of the substrates 33 is elevated to about 200°C which is suitable for forming a silicon nitride film. In the reaction chamber 31 there is circulated a process gas at a pressure of several Torr (1 Torr = $133.3N/M^2$). The process gas is irradiated through quartz windows 47 with light from the light sources 41. The numeral 45 designates electrodes by virtue of which a discharge can be caused to take place within the chamber using the carrier as a second electrode and undesired products deposited on the surfaces of the quartz windows 47 can be eliminated by sputtering.

A disadvantage of the apparatus of Fig. 1 is that the quartz windows 47 have to be sufficiently thick to bear the differential pressure between the inside of the reaction chamber 31 and the inside of the light source chamber 39 in which cooling gas is circulated in order that leakage of the cooling gas from the light source chamber 39 into the reaction chamber 31 can be avoided. As an alternative, a special cooling system may need to be provided for the light source chamber 39 so that the pressure in the light source chamber, and therefore the differential pressure, can be decreased. Also, when it is desired to cause a discharge between the carrier 35 and the reaction chamber 31 to remove undesired film deposited on the light windows by sputtering, the discharge tends to deviate from the windows; because of this, the special electrodes 45 have to be provided which makes the size of the apparatus large.

Another disadvantage of the apparatus of Fig. 1 is that the thickness of deposited film depends on the spatial relationship between the light sources and the positions of the substrates. Namely, the product of the CVD process may be deposited with a greater thickness at positions which are irradiated with stronger light. Generally speaking, the tolerable fluctuation of the thickness of the film is about 10%. The problem of the unevenness of the film deposited by CVD is also a problem in the case of plasma enhanced CVD. The energy of the plasma seems to be dependent upon the relationship between the substrate and the pair of electrodes between which the discharge takes place. Uniform film deposition on a substrate to be coated is also a requirement for plasma CVD.

## SUMMARY OF THE INVENTION

According to one aspect of the present invention there is provided a photo-enhanced CVD apparatus comprising an evacuable reaction chamber, means for inputting process gases into said reaction chamber, a generally columnar substrate holder mounted within said reaction chamber, said substrate holder having peripheral surfaces capable of holding a plurality of substrates, and a plurality of elongate light sources generally uniformly arranged around the substrate holder for irradiating substrates thereon, said light sources each comprising a UV light source housed within a tubular light-transmitting enclosure which is hermetically sealed with respect to the interior of the reaction chamber.

The embodiments of the present invention which are described hereinafter comprise CVD apparatuses wherein, furthermore, the spatial relationship relative to the apparatus of a substrate mounted on a carrier of the apparatus is varied during the CVD process so as to reduce the deleterious effect of any non-homogenuities in the spatial arrangement of the apparatus upon the uniformity of deposits effected in the apparatus. The carrier may for example be rotatably mounted in the apparatus so as to ensure that the exposure of a substrate mounted on the carrier to the effects of the photo-and/or plasma-enhancement means of the apparatus is uniform throughout the substrate area.

In accordance with preferred embodiments which will be described hereinafter, a generally cylindrical multi-faceted prismatic carrier is utilized which is arranged to be rotated about its axis during the CVD process, and the photo-enhancement means is provided so as to surround the rotary carrier. Such a carrier can have many faces and is capable of achieving uniform deposits on the surfaces of substrates mounted on all of its faces.

The uniformity can further be enhanced by control of the speed of rotation of the carrier and/or by control of the intensity of the effects of the enhancement means.

The above and other features and aspects of the invention are set forth with particularity in the appended claims and will become clear to those possessed of the relevant skills from consideration of the following description given with reference to the accompanying drawings.

## BRIEF DESCRIPTION OF THE DRAWINGS

Fig. 1 is a cross sectional view of an example of a photo CVD apparatus;

Fig. 2 is a cross sectional view showing an exemplary embodiment of the invention;

Fig. 3 is a cross sectional view taken along the line III-III of Fig. 2;

Fig. 4 is a cross sectional view showing another exemplary embodiment of the invention.

Figs.5(A) to 5(C) are graphical diagrams showing the distribution of the illumination intensity of substrates mounted on prism-shaped substrate holders having cross sections in the form of regular polygons of 6, 12 and 24 sides; and

Figs.6(A) to 6(C) and Fig.7 are sectional views showing stages of an exemplary CVD process in accordance with this invention.

## DETAILED DESCRIPTION OF THE PREFERRED EMBODIMENTS

Referring to Fig.2 and Fig.3, a photo enhanced CVD apparatus in accordance with the invention is illustrated. As shown in the figures, the apparatus 1 comprises a reaction chamber 3, a hexagonal carrier 7 serving as a substrate holder and having six lateral faces on which substrates 15 can be mounted, a driving arrangement 9 including a motor 21 for rotating the carrier 7 around its axis, a plurality of quartz tubes 17 spaced from each other at constant angular distances about the carrier, the tubes being sealed to the inside of the reaction chamber 3 at one end, and at the other end being closed, mercury lamps 19 provided in and housed air-tightly by the quartz tubes, halogen lamp heaters 23 arranged along the axial direction of the carrier, a process gas introduction system 11, and an evacuation system 13. A cooling gas, such as nitrogen gas, is circulated in the quartz tubes 17 by means of recirculation means 29. On each planar face of the carrier 7, two substrates each 35cm long and 30cm wide can be mounted, and therefore the carrier 7 can hold twelve substrates thereon. The carrier is preferentially detachable from the driving arrangement so that the substrates can be mounted on the carrier outside of the reaction chamber 3.

Next, the method of use of the apparatus will be explained. First, twelve substrates are mounted on the carrier 7 and inserted into the reaction chamber 3. After evacuating the reaction chamber 3 to $10^{-2}$ to $10^{-6}$ Torr by means of the evacuation system 13, process gas is inputted from the introduction system 11 at about 3 Torr. Simultaneously, the substrates 15 are heated by the heater 23 to about 200°C. Then, the carrier 7 encircled by the mercury lamps 19 is rotated at 2 rpm by the driving arrangement 9 and irradiated with ultraviolet light from the lamps 19, whereupon the product of a reaction initiated by optical energy is deposited on the substrates 15. Any reaction product undesirably deposited on the quartz tubes 19 can be removed by sputtering by establishing a discharge between the carrier 7 and the reaction chamber 3. A photo enhanced CVD process may be carried out, e.g., in accordance with the following equation:

$$3Si_2H_6 + 8NH_3 \dashrightarrow 2Si_3N_4 + 21H_2 \text{ or}$$
$$SiH_4 + 4N_20 \dashrightarrow Si0_2 + 4N_2 + 2H_20 \qquad (1)$$

Referring now to Fig.4, another embodiment of the invention is illustrated. This embodiment is the same as the preceding embodiment except for the number of side faces of the carrier and for the provision of an electrode 49 in the form of a cylindrical wire net disposed between the carrier 7 and the reaction chamber 3. The carrier 7 in the Fig.4 embodiment has twelve side faces each capable of holding two substrates. The electrode 49 is used both for generating a plasma gas by virtue of a discharge established between itself and the carrier 7, and for carrying out etching for eliminating any undesired CVD product deposited on the inside wall of the reaction chamber 3, on the external surfaces of the light sources 5 and so forth. The electrode 49 could alternatively be placed between the light sources 5 and the carrier 7. Plasma enhanced CVD may be implemented in the illustrated apparatus simultaneously with photo CVD by causing a plasma discharge within the reaction chamber during the photo CVD process, or may be implemented separately after or instead of deposition by photo CVD. Plasma CVD may be carried out, e.g., using TEOS (tetra-ethyl-oxy-silane) in accordance with the following equations:

$Si0_4(C_2H_5)_4 + 140_2 \rightarrow Si0_2 + 8C0_2 + 10H_20$, or
$Si0_4(C_2H_5)_4 + 28N_20 \rightarrow Si0_2 + 8C0_2 + 10H_20 + 28N_2$ (2)

After removal from the reaction chamber of the substrates on which the deposition has been completed, any undesirable deposited product formed on the inside of the reaction chamber may be removed by etching by virtue of a discharge established between the carrier 7 and the electrode 49. The etching is carried out, e.g., in accordance with the following equations:

$Si_3N_4 + 4NF_3 \rightarrow 3SiF_4 + 4N_2$
$3Si0_2 + 4NF_3 \rightarrow 3SiF_4 + 2N_2 + 30_3$

The relationship between the uniformity of the illumination intensity on the substrate and the number of side faces of the carrier has been experimentally investigated. Figs.5(A) to 5(C) are graphical diagrams showing the distributions of the intensity on substrates mounted on prism-shaped substrate holders having cross sections in the form of regular polygons of 6, 12 and 24 sides. In the figures, the abscissa represents the distance of the measuring point from the center of a substrate, and the ordinate represents the intensity normalized with reference to the maximum intensity measured on the substrate. As shown from the diagrams, the distribution of the intensity becomes more uniform as the number of faces on the carrier increases. The intensity fluctuates over the irradiated surface by more than 10% in the case of a carrier having six faces, while the fluctuation of the intensity is limited to within 5% in the cases of carriers having twelve and twenty-four faces. The carrier having twenty-four faces may hold forty-eight substrates by mounting two substrates on each face.

Figs.6(A) to 6(C) are cross sectional views showing an example of a CVD process in accordance with the present invention. The surface of a substrate 15 to be coated is provided with a plurality of aluminium lead lines 51. The lead lines 51 are elongate in the direction perpendicular to the drawing sheet and may for example be 0.8 micron in height and 0.6 micron in width and spaced apart at 0.9 micron intervals as shown in Fig.6(A). A silicon oxide film is deposited on the substrate over the leads 51 by photo CVD in accordance with the equation (1) to a thickness of 0.3 to 0.5 micron at about 400°C as shown in Fig.6(B). Further, another silicon oxide film 55 is deposited by plasma CVD in accordance with the equation (2) at 200°C as shown in Fig.6(C). The film 53 has excellent insulating properties due to its comparatively high formation temperature while the film 55 provides an even upper surface due to the use of TEOS in a liquid state at a comparatively low temperature in its formation. The even upper surface is desirable when provided with an overlying aluminium electrode 57 as shown in Fig.7. The likelihood of discontinuities arising in electrode 57 is reduced by virtue of the evenness of the surface of the film 55. After the completion of the deposition, the inside of the reaction chamber may be cleaned by etching for example to remove CVD products deposited on the mercury lamps 19, only one such lamp being schematically shown in Figs. 6(A) to 6(C). An etching process can be implemented on the deposited film before or after plasma CVD in order to obtain an even surface on the film or to chamfer the edge of the deposited film.

By use of the above process, film can be deposited with a virtually constant thickness throughout the surface of the substrate 15 by virtue of the uniform irradiation obtained over each substrate. However, the uniformity of the film thickness can be further improved by modulating the intensity of the mercury lamps 19 in synchronization with the rotation of the carrier 7, or by modulating the angular speed of the carrier 7 in correspondence with its position relative to the mercury lamps 19.

The invention should not be regarded as being limited to the above described particular embodiments and many modifications and variations may occur to those skilled in the art without departure from the invention. For example, as the cross section of the carrier 7, other regular or irregular polygonal or circular shapes can be employed. Also the driving arrangement can be provided on the top side of the reaction chamber, or on the lateral side with a pinion drive gear being provided, instead of on the bottom side as shown in Fig. 2.

The present application was divided from European Patent Application No. 87307896.8 (EP 0 260 097) which claims a photo-enhanced CVD apparatus comprising an evacuable reaction chamber, means for inputting process gases into said reaction chamber, a generally columnar substrate holder mounted within said reaction chamber, said substrate holder having peripheral surfaces capable of holding a plurality of substrates, a plurality of elongate light sources generally uniformly arranged around the substrate holder for irradiating substrates thereon, said elongate light sources extending generally parallel to the substrate holding surfaces of the substrate holder and having a length at least equal to the corresponding length dimension of the substrate holding surfaces of the substrate holder, and means for varying the spatial relationship relative to the light sources of the substrate holder so as in use of the apparatus to enable the formation of uniform deposits upon substrates held on the peripheral surfaces of the substrate holder irrespective of any non-homogenuities in the spatial arrangement of the apparatus.

## Claims

1. A photo-enhanced CVD apparatus comprising an evacuable reaction chamber (3), means (11) for inputting process gases into said reaction chamber, a generally columnar substrate holder (7) mounted within said reaction chamber, said substrate holder having peripheral surfaces capable of holding a plurality of substrates (15), and a plurality of elongate light sources (19) generally uniformly arranged around the substrate holder for irradiating substrates thereon, said light sources (19) each comprising a UV light source housed within a tubular light-transmitting enclosure (17) which is hermetically sealed with respect to the interior of the reaction chamber (3).

2. The apparatus of claim 1 wherein said elongate light sources (19) extend generally parallel to the substrate holding surfaces of the substrate holder (17) and have a length at least equal to the corresponding length dimension of the substrate holding surfaces of the substrate holder.

3. The apparatus of claim 1 or 2 wherein the substrate holder (7) is polygonal and has a plurality of planar substrate holding surfaces.

4. The apparatus of claim 3 wherein the polygonal substrate holder (7) has at least twelve substrate holding surfaces.

5. The apparatus of any preceding claim wherein the substrate holder (7) is generally cylindrical.

6. The apparatus of any preceding claim wherein said UV light sources (19) comprise discharge lamps (19) encased within hermetically sealed transparent cylindrical tubes (17).

7. The apparatus of claim 6 wherein said tubes (17) are formed of quartz.

8. The apparatus of claim 6 or 7 wherein means (29) are provided for circulating a cooling gas within said tubes (17) for cooling said lamps (19).

9. The apparatus of any preceding claim wherein the generally cylindrical substrate holder (7) is hollow and heating means (23) are provided within the hollow interior of the substrate holder for heating substrates held thereby.

10. The apparatus of any preceding claim wherein an electrode (49) is provided in said reaction chamber (3) for enabling a plasma discharge to be established therein for implementing plasma enhanced CVD within the apparatus, for removing undesired deposits from the interior of the reaction chamber by plasma etching, or for plasma etching a film deposited in use of the apparatus.

11. A photo enhanced CVD apparatus comprising:
a reaction chamber (3);
a substrate holder (7) on which at least one substrate may be mounted;
at least one light source (19) provided in said reaction chamber for irradiating a substrate mounted on said substrate holder;
process gas inputting means (11); and
exhaustion means (13);
said at least one light source (19) being housed in a hermetically sealed transparent tube (17).

12. The apparatus of claim 11 wherein said at least one light source (19) is a mercury lamp.

13. The apparatus of claim 11 or 12 further comprising a system (29) for circulating a cooling gas through said transparent tube (17).

14. The apparatus of claim 13 wherein said cooling gas is nitrogen gas.

15. The apparatus of claim 13 or 14 wherein said tube (17) is a quartz tube one end of which is closed and the other end of which is connected with said circulating system (29).

16. A photo enhanced CVD apparatus comprising:
a vacuum chamber (3);
a vacuum pump (13) for evacuating said vacuum chamber;
a gas feeding system (11) for supplying a reaction gas into said vacuum chamber;

a substrate holder (7) provided in said vacuum chamber; and

a plurality of transparent cylinder-shaped tubes (17) provided around said substrate holder, each of said plurality of tubes (17) being provided with a UV light source (19) and being hermetically sealed with respect to the vacuum chamber.

FIG.1

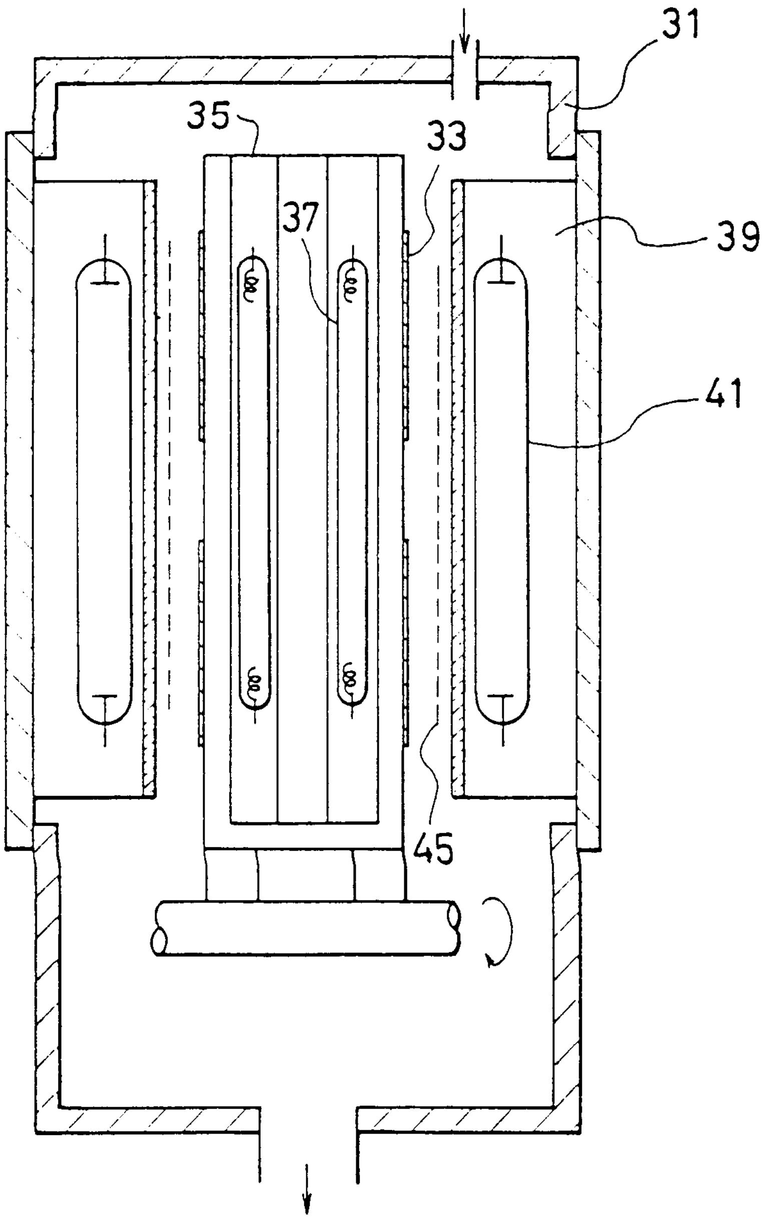

FIG.2

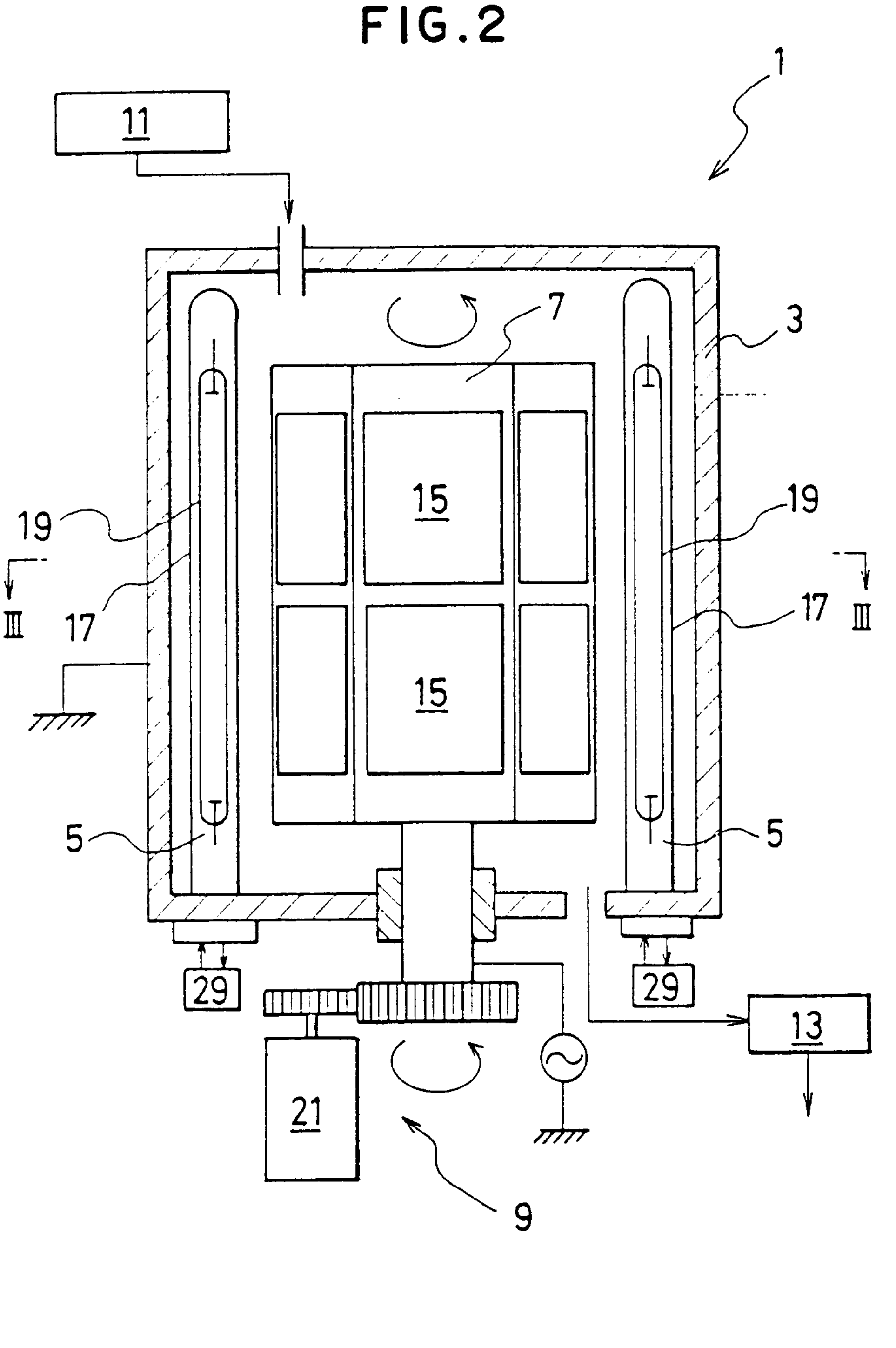

FIG.3

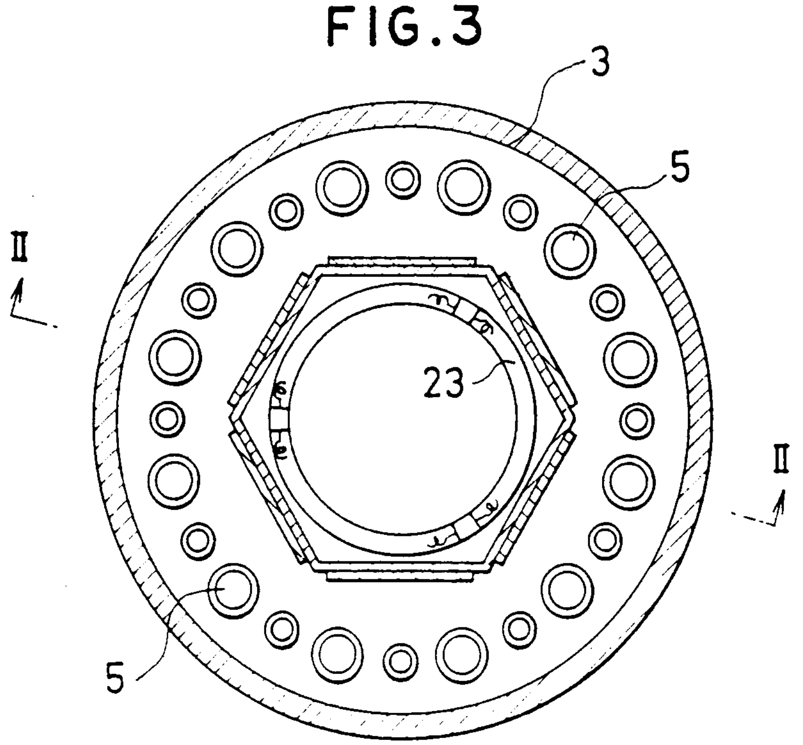


FIG.4

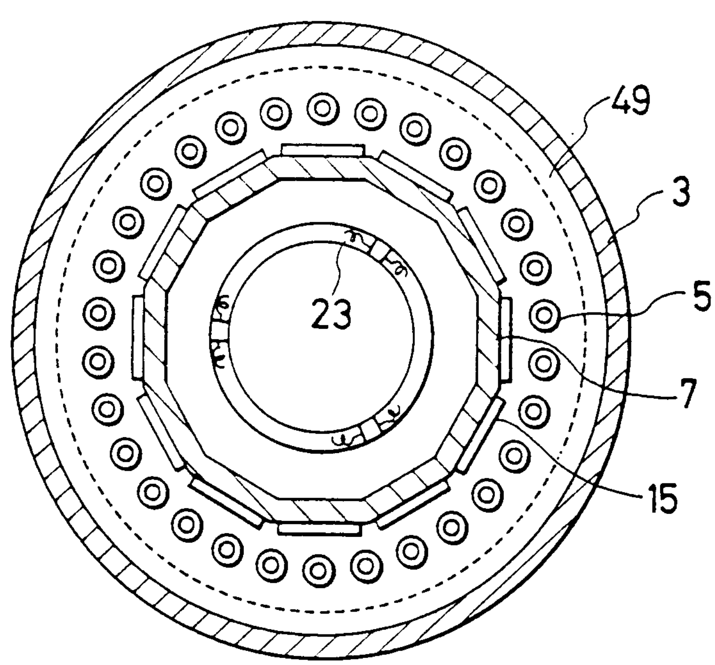

FIG.5(a)

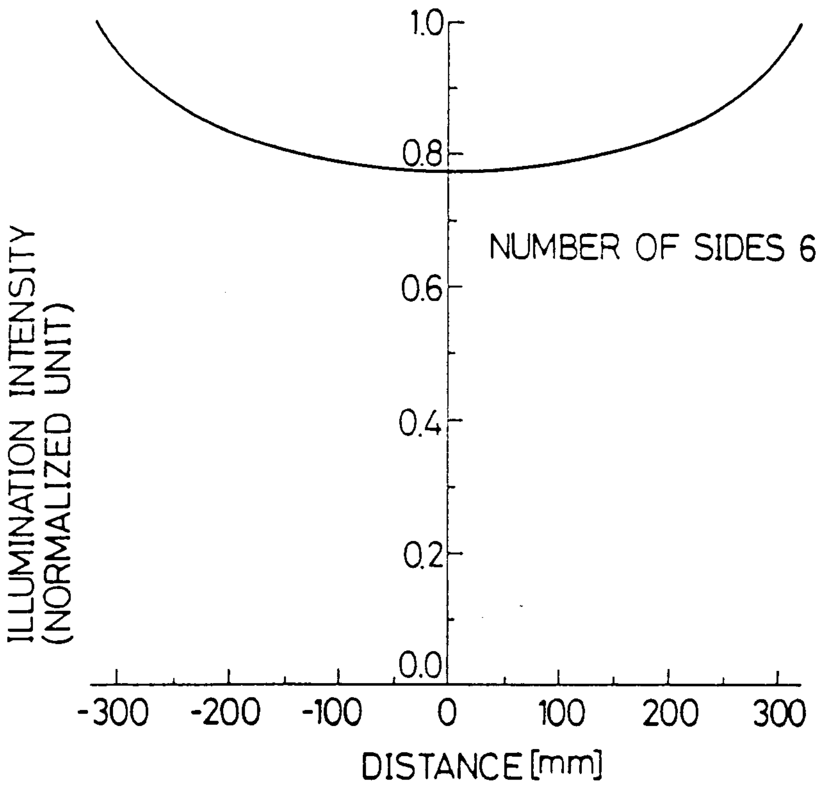
1.0
0.8
0.6
0.4
0.2
0.0
NUMBER OF SIDES 6
ILLUMINATION INTENSITY
(NORMALIZED UNIT)
-300
-200
-100
0
100
200
300
DISTANCE [mm]

FIG.5(b)

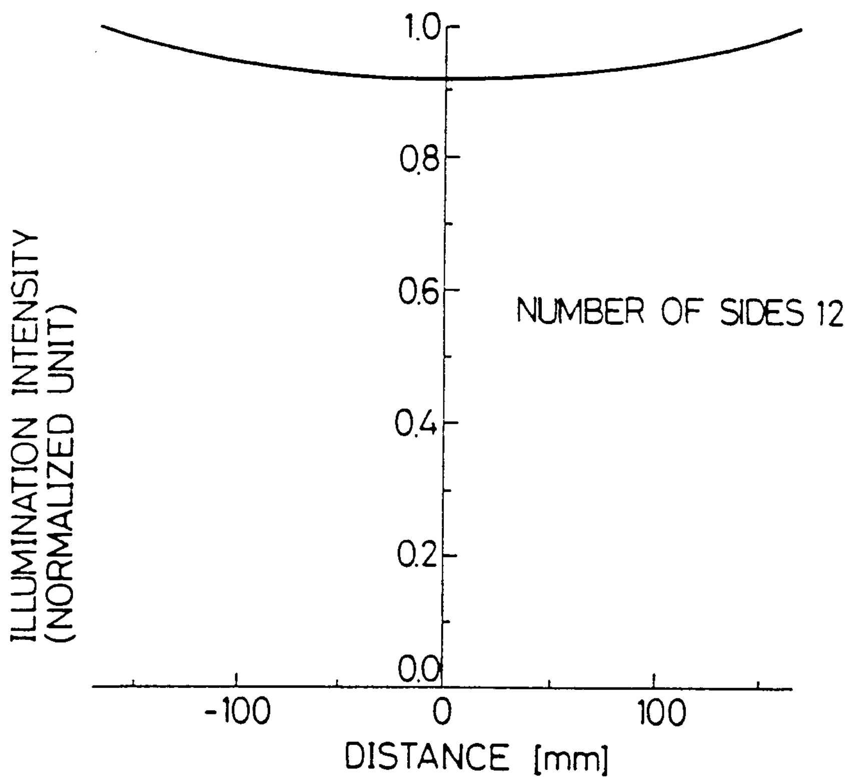
1.0
0.8
0.6
0.4
0.2
0.0
ILLUMINATION INTENSITY
(NORMALIZED UNIT)
NUMBER OF SIDES 12
-100
0
100
DISTANCE [mm]

FIG.5(c)

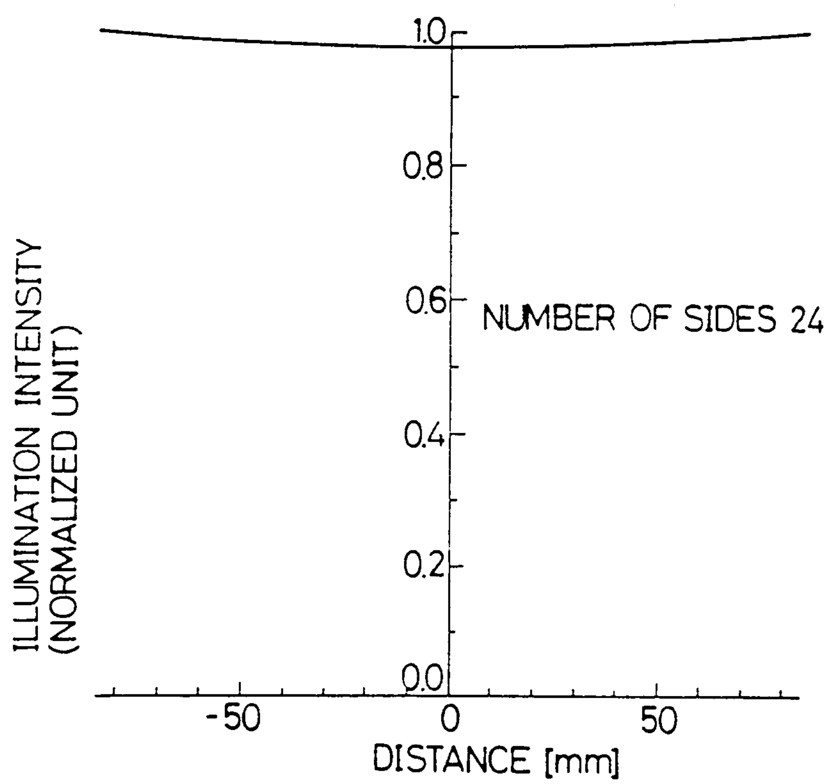
1.0
0.8
0.6
0.4
0.2
0.0
NUMBER OF SIDES 24
ILLUMINATION INTENSITY
(NORMALIZED UNIT)
-50
0
50
DISTANCE [mm]

FIG.6(a)

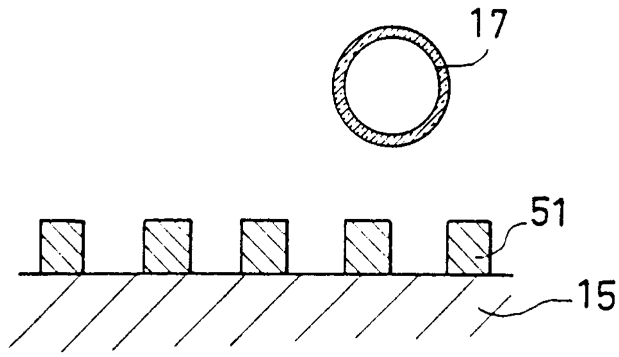


FIG.6(b)

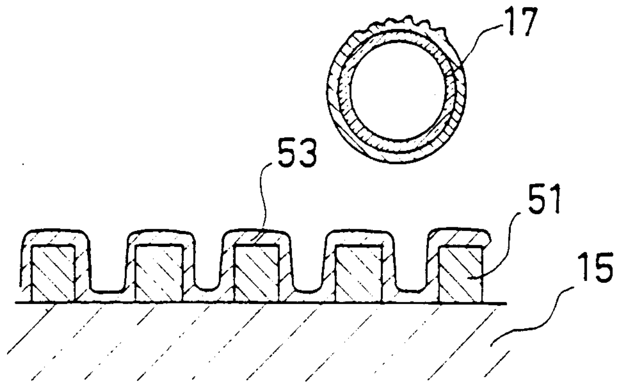


FIG.6(c)

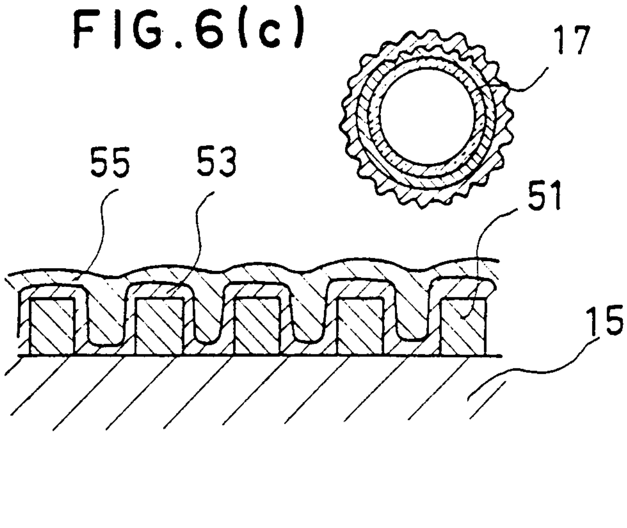

FIG.7

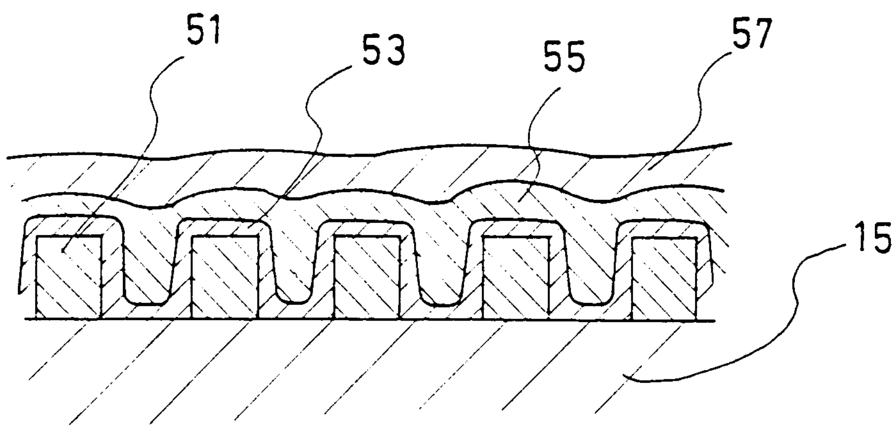

European Patent Office

# EUROPEAN SEARCH REPORT

Application Number

EP 92 10 4124

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 567 352 (MIMURA ET AL.)<br>--- | | C23C16/48 |
| A | PATENT ABSTRACTS OF JAPAN<br>vol. 8, no. 221 (E-271)(1658) 9 October 1984<br>& JP-A-59 104 120 ( FUJITSU ) 15 June 1984<br>* abstract *<br>--- | | |
| A | JAPANESE JOURNAL OF APPLIED PHYSICS.<br>vol. 23, no. 10, October 1984, TOKYO JP<br>KAMISAKO ET AL.: 'ANALYSIS OF DEPOSITION RATE DISTRIBUTION IN THE PHOTO-CVD OF a-Si BY A UNIFIED REACTOR WILTH A LAMP'<br>PAGES L776-L778<br>----- | | |
| | | | TECHNICAL FIELDS SEARCHED (Int. Cl.4) |
| | | | C23C<br>C30B |

The present search report has been drawn up for all claims

| Place of search | Date of completion of the search | Examiner |
|---|---|---|
| THE HAGUE | 06 APRIL 1992 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document